# EUROPÄISCHE PATENTSCHRIFT

(11) **EP 3 631 924 B1**
(45) Veröffentlichungstag und Bekanntmachung des Hinweises auf die Patenterteilung: **15.09.2021**
(21) Anmeldenummer: 18726966.7
(22) Anmeldetag: 22.05.2018
(51) Int. Cl.: H02B 1/28

(54) **EXPLOSIONSSICHERES GEHÄUSE MIT DRUCKENTLASTUNG**
EXPLOSION-PROOF HOUSING WITH PRESSURE RELIEF
BOÎTIER ANTIDÉFLAGRANT AVEC DISPOSITIF DE DÉCHARGE DE PRESSION

(30) Priorität: 01.06.2017 DE 102017112153
(43) Veröffentlichungstag der Anmeldung: 08.04.2020
(73) Patentinhaber: R. Stahl Schaltgeräte GmbH, 74638 Waldenburg (DE)
(72) Erfinder: ARNHOLD, Thorsten, 74629 Pfedelbach (DE); HERMANOWSKI, Clife, 74743 Seckach (DE)
(74) Vertreter: Rüger Abel Patentanwälte PartGmbB
(86) Internationale Anmeldenummer: PCT/EP2018/063338
(87) Internationale Veröffentlichungsnummer: WO 2018/219712

(56) Entgegenhaltungen:
- EP-A1- 0 592 757
- DE-A1-102015 206 355
- US-A- 2 789 238
- US-A- 4 484 690
- US-A1- 2015 060 465

## Beschreibung

Gegenstand der Erfindung ist ein explosionsgeschütztes Gehäuse, insbesondere ein Gehäuse der Schutzart Ex-d, nach Anspruch 1.

Gehäuse der Schutzart Ex-d werden häufig in explosionsgefährdeten Bereichen eingesetzt. Solche Gehäuse sind so robust ausgebildet, dass sie einer im Gehäuseinneren stattfindenden Zündung eines explosiven Gasgemisches und der darauf folgenden Druckerhöhung standhalten. Außerdem sind die Gehäuse so gestaltet, dass keine Flammen oder glühende, als Zündquellen wirkende Partikel nach außen gelangen können. Sollten Spalte vorhanden sein, müssen diese eine Mindestlänge aufweisen und dürfen eine Höchstweite nicht überschreiten. Außerdem sind Gehäuseöffnungen mit Druckentlastungskörpern versehen, die auch als Flammenschutzfilter bezeichnet werden und verhindern, dass eine im Gehäuse gezündete Explosion nach außen dringt und in der Umgebung vorhandenes explosionsfähiges Gemisch zündet.

Ein Beispiel für ein explosionsgeschütztes Gehäuse ist der DD 261 063 A3 zu entnehmen. Das dort veranschaulichte Gehäuse weist in seinem Innenraum einen porösen Körper beispielsweise aus Schlackenwolle, Glaswolle oder Metall oder Keramik mit offenen durchgehenden Poren oder Spalten auf. Dieser Körper soll zu einer Senkung des Explosionsdrucks um ca. 90% führen.

Ebenso offenbart die DE 198 60 386 B4 ein für einen Bildschirm vorgesehenes Gehäuse, dessen Innenraum teilweise mit einem porösen Explosionsdruck-Dämpfungsmaterial gefüllt ist. Dieses weist eine Vielzahl im Querschnitt kleiner, nicht geschlossener, sondern durchgehender Kanäle in Form von Poren und/oder Spalten auf. Der Explosionsdruck soll auf lediglich etwa 10% des Explosionsdrucks gedämpft werden, der sonst in dem leeren Gehäuse auftreten würde.

Ähnlich sieht die DE 10 2014 206 433 B3 die Anordnung eines Tablets-Computers in einem mit einer Glasscheibe versehenen explosionssicheren Gehäuse auf, wobei in dem Tablet-Computer ein Dämpfungselement aus offenporiger Stein-, Quarz- oder Glaswolle, Metallschaum oder dergleichen, angeordnet ist.

Die insoweit vorgestellten Gehäuselösungen erfordern zur Senkung des Explosionsdrucks Dämpfungskörper mit erheblichem Volumen, womit der Gehäuseinnenraum nur unzulänglich ausgenutzt wird.

Aus der DE 10 2013 109 259 A1 ist dagegen ein explosionsgeschütztes Gehäuse der Schutzart "druckfeste Kapselung" (Ex-d) bekannt, in dessen Gehäusewand ein poröser Druckentlastungskörper vorgesehen ist, durch den ein im Gehäuse aufgebauter Explosionsdruck nach außen dringen kann.

Das Dokument DE 10 2013 109 260 A1 offenbart ferner die Präambel des unabhängigen Anspruchs 1.

Ein ähnliches Prinzip nutzen die Gehäuse nach der US 4,180,177 sowie nach der DE 10 2010 016 782 B4.

Außerdem ist aus der DE 10 2014 116 149 A1 ein vorteilhafter Aufbau eines Druckentlastungskörpers bekannt. Dieser besteht aus mehreren Drahtgewebelagen unterschiedlicher Ausrichtung und Maschenweite, wobei diese Lagen durch einen Sinterprozess miteinander verbunden worden sind. Bei Anordnung solcher Gehäuse in widriger Umgebung, beispielsweise mit Staub beladener Atmosphäre oder mit direkter Wetterbeaufschlagung, bedürfen die Druckentlastungskörper in den Gehäuseöffnungen besonderen Schutzes, beispielsweise gegen Verschmutzung, Verkeimung, Korrosion und/oder Vereisung.

Es ist Aufgabe der Erfindung, ein Konzept für ein explosionsgeschütztes Gehäuse anzugeben, mit dem sich ein oder mehreren der oben genannten Nachteile vermeiden lassen.

Diese Aufgabe wird mit der explosionsgeschützten Gehäuseanordnung nach Anspruch 1 gelöst.

Die erfindungsgemäße Gehäuseanordnung weist ein Gehäuse auf, das einen Innenraum umschließt, der zur Aufnahme von Komponenten geeignet ist, die Zündquellen bilden können. In dem Gehäuse ist ein Entlastungsvolumen vorgesehen. Dieses ist in dem Innenraum angeordnet. Es ist dabei wenigstens eine Durchgangsöffnung vorgesehen, die den Innenraum mit dem Druckentlastungsvolumen verbindet, wobei in dieser Durchgangsöffnung eine gasdurchlässige und flammendurchschlagsichere Anordnung angeordnet ist. Bei dieser handelt es sich typischerweise um einen porösen, mechanisch stabilen Körper mit einer Vielzahl von vorzugsweise ein- oder mehrfach verzweigten Porenkanälen, die zwei voneinander weg weisende Seiten des Körpers miteinander verbinden. Der Druckentlastungskörper kann beispielsweise ein poröser Metallkörper, poröser Keramickörper, poröser Glaskörper, ein aus Metallpartikeln oder Keramikpartikeln gesinterter Körper oder ein aus mehreren miteinander verbundenen Drahtnetzlagen bestehender Körper sein.

Der Druckentlastungskörper kann mit der Wandanordnung verklebt, verschweißt oder auch mechanisch zum Beispiel durch einen Klemmrahmen, durch Klemmschrauben oder dergleichen verbunden sein. Der Druckentlastungskörper kann an der Gehäusewand angebracht oder beim Urformen der Gehäusewand in diese eingebracht sein.

Erfindungsgemäß befindet sich auf einer Seite der flammendurchschlagsicheren Anordnung derjenige Teil des Innenraums, in dem Zündquellen bildende Komponenten angeordnet sind während auf der anderen Seite der flammendurchschlagsicheren, gasdurchlässigen Anordnung ein Volumen abgegrenzt ist, das frei von Zündquellen bildenden Komponenten ist. Beispielsweise kann der die Komponenten enthaltende Teil des Innenraums zu einem explosionsgeschützten Gehäuse Ex-d gehören, während das Druckentlastungsvolumen nach einer anderen Schutzart, zum Beispiel Ex-e, ausgebildet ist. Es kann somit zur Umgebung hin offene Öffnungen aufweisen. Jedenfalls aber ist die gasdurchlässige flammendurchschlagsichere Anordnung direkten Umgebungseinflüssen und somit Staubablagerung, Vereisung usw. entzogen.

Die Kombination der gasdurchlässigen und flammendurchschlagsicheren Anordnung, zum Beispiel in Gestalt eines steifen, porösen Körpers (beispielsweise eines Metallnetzlagen-Sinterkörpers), mit einem Druckentlastungsvolumen, vermindert im Vergleich zu Dämpfungskörpern, wie sie aus dem Stand der Technik bekannt sind, den Volumenbedarf der Druckreduzierungsanordnung. Diese besteht bei der Erfindung aus der gasdurchlässigen flammendurchschlagsicheren Anordnung und dem das Druckentlastungsvolumen enthaltenden Teilgehäuse. Letzteres hat im Vergleich zu einem gleich großen porösen Körper ein höheres Schluckvermögen. Durch die expansionsbedingte Abkühlung der den porösen Körper durchdringenden Gasmenge wirkt das Druckentlastungsvolumen besonders stark druckreduzierend. Auch ist der Strömungswiderstad des freien Druckentlastungsvolumens deutlich geringer als der Strömungswiderstand innerhalb eines porösen Dämpfungskörpers, was insbesondere dem Abbau der Druckspitze nach Auslösung einer Explosion dient.

Weitere Einzelheiten vorteilhafter Ausführungsformen der Erfindung sind Gegenstand der beigefügten Ansprüche. Es zeigen:
Figur 1 ein explosionsgeschütztes Gehäuse, nicht Teil der Erfindung, mit Druckentlastungsvolumen und dazwischen angeordnetem Druckentlastungskörper, in schematisierter Schnittdarstellung,
Figur 2 bis 4 weitere Beispiele, nicht Teil der Erfindung, und Figur 5, eine Ausführungsform der vorliegenden Erfindung explosionsgeschützter Gehäuse mit Druckentlastungsvolumen jeweils, in schematisierter Schnittdarstellung,
Figur 6 ein nicht Teil der Erfindung doppelwandiges explosionsgeschütztes Gehäuses mit als Druckentlastungsvolumen dienenden Wandinnenräumen, in schematisierter Schnittdarstellung, und
Figur 7 ein nicht Teil der Erfindung explosionsgeschütztes doppelwandiges Gehäuse mit Wandvolumina, die mit porösem Material wenigstens teilweise gefüllt sind.

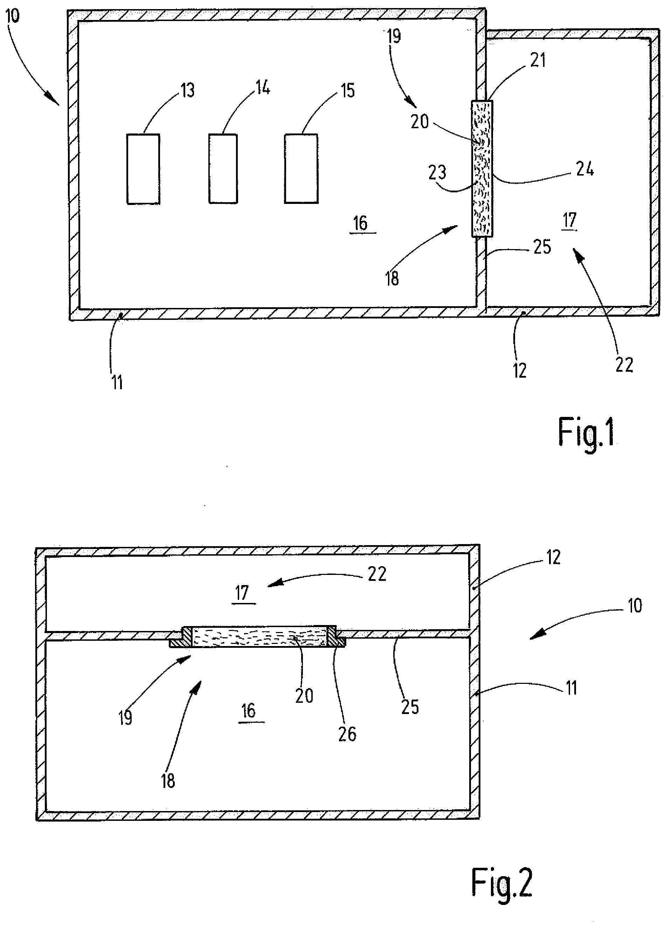

In Figur 1 ist eine Gehäuseanordnung 10 veranschaulicht, zu der ein Gehäuse 11 und ein Teilgehäuse 12 gehören. Das Gehäuse 11 enthält eine oder mehrere elektrische oder sonstige Komponenten 13, 14, 15, die in einem von dem Gehäuse 11 umschlossenen Innenraum 16 angeordnet sind und Zündquellen für ein dort möglicherweise vorhandenes explosives Gasgemisch bilden können.

Das Gehäuse 11 besteht typischerweise aus Metall, beispielsweise Stahl oder Aluminium, es kann jedoch auch aus einem geeigneten Kunststoff oder Kunststoffverbundmaterial ausgebildet sein. Es schließt unmittelbar an das Teilgehäuse 12 an, das aus gleichem oder anderem Material bestehen kann. Das Teilgehäuse 12 umschließt ebenfalls einen Innenraum 17, in dem keine weiteren Bauteile oder Komponenten oder wenigstens keine Bauteile oder Komponenten angeordnet sind, die Zündquellen bilden können. Solche Komponenten können beispielsweise ruhende Kontakte z.B. in Form von elektrischen Anschlusskontakten sein. In diesem Fall ist das Gehäuse 11 zum Beispiel nach der Schutzart Ex-d (druckfeste Kapselung) ausgebildet, was bedeutet, dass jede Verbindung zwischen dem Innenraum 16 und der Umgebung flammendurchschlagssicher ausgebildet ist, wobei die Gehäusewand des Gehäuses 11 der Druckbelastung einer im Innenraum 16 stattfindenden Explosion standhält. Das Teilgehäuse 12 kann hingegen nach einer anderen Schutzart, zum Beispiel Ex-e ausgebildet sein, was bedeutet, dass in dem Innenraum 17 keine Zündquellen bildenden Elemente vorgesehen sind.

Es ist auch möglich, sowohl das Gehäuse 11 als auch das Teilgehäuse 12 nach gleichem Standard, z.B. als druckfeste Kapselung nach (Ex-d) auszubilden. In diesem Falle können sowohl in dem Gehäuse 11 als auch in dem Teilgehäuse 12 Zündquellen bildende Komponenten vorhanden sein. Dies insbesondere, wenn die in den beiden Innenräumen 16, 17 vorhandenen potentiellen Zündquellen nicht gleichzeitig aktiv sind.

Das Gehäuse 11 weist an einer Wand 25 eine Durchgangsöffnung 18 auf, die den Innenraum 16 mit dem Innenraum 17 verbindet. Die Wand 25 ist integraler Bestandteil des Gehäuses 11 oder des Teilgehäuses 12. In oder an der Durchgangsöffnung 18 ist eine flammendurchschlagsichere Anordnung 19 vorgesehen, die gasdurchlässig ausgebildet und beispielsweise durch einen porösen Körper 20 gebildet ist. Dieser kann beispielsweise ein Metallschaumkörper, Keramikschaumkörper oder ein aus Drahtgewebe, Drahtgestrick, Drahtfilz oder dergleichen gebildeter Körper sein. Insbesondere ist der poröse Körper 20 biegesteif ausgebildet und an seinem Rand 21 mit der Gehäusewand verbunden. Die Verbindung ist vorzugsweise spaltfrei, so dass durch die Durchgangsöffnung 18 strömendes Gas den porösen Körper 20 nicht umgehen kann.

Die insoweit beschriebene Gehäuseanordnung 10 kann in explosionsgefährdeter Umgebung eingesetzt werden. Sollten durch nicht weiter veranschaulichte Spalte oder auf sonstigem Wege explosionsfähige Gase in den Innenraum 16 und gegebenenfalls auch 17 eingedrungen sein, können diese an einer der Komponenten 13 bis 15 das Gas zu einem zufälligen Zeitpunkt zünden und zu einer Explosion in dem Innenraum 16 führen. Das Gehäuse 11 weist keine Öffnungen oder Spalten auf, durch die Flammen oder heiße Partikel nach außen dringen könnten. Alle Fugen, Spalten und sonstigen nicht gasdichten Strukturen sind flammendurchschlagsicher.

Die in dem Innenraum 16 initiierte Explosion führt zunächst zu einer Erwärmung und Ausdehnung des vorhandenen Gasvolumens, was mit einer Druckerhöhung einhergeht. Die flammendurchschlagsichere Anordnung 19 bewirkt jedoch eine Druckentlastung, indem sie einen Gasstrom aus dem Innenraum 16 in den Innenraum 17 übertreten lässt. Die durch den porösen Körper 20 in den Innenraum 17 dringenden Gase kühlen sich durch Wärmeabgabe an dem porösen Körper 20 sowie durch Expansion zum Beispiel adiabatisch und/oder durch den Jules Thompson Effekt ab. Dadurch kann der Innenraum 17 ein Gasvolumen aufnehmen, das größer ist als das Gasvolumen, das den Innenraum 16 durch die Durchgangsöffnung 18 verlassen hat. Der Innenraum 17 bildet somit ein sehr wirksames Druckentlastungsvolumen 22 für den Innenraum 16.

Zusätzlich hält das Teilgehäuse 12 Umwelteinflüsse von der flammendurchschlagsicheren Anordnung 19 fern, so dass diese insbesondere vor Verstaubung, Verschmutzung, Verkeimung, Vereisung und dergleichen Einflüssen geschützt ist. Insbesondere werden Umwelteinflüssen ferngehalten, die zu einer Verringerung der Gasdurchlässigkeit der flammendurchschlagsicheren Anordnung 19 führen können.

Sowohl die im Innenraum 16 zugewandte Fläche 23 als auch die im Druckentlastungsvolumen 22 zugewandte Fläche 24 sind dauerhaft geschützt.

Figur 2 veranschaulicht ein abgewandeltes Beispiel der Gehäuseanordnung 10, bei der das Gehäuse 11 und das Teilgehäuse 12 durch einen gemeinsamen Gehäusekörper gebildet sind. Das Druckentlastungsvolumen 22 ist von dem Innenraum 16 durch eine Zwischenwand 25 abgetrennt, die integraler Bestandteil des Gehäusekörpers ist und in der die Durchgangsöffnung 18 mit der darin angeordneten Druckentlastungsanordnung 19 angeordnet ist. Der zu dieser gehörige poröse Körper 20 kann wiederum auf jede geeignete Art mit dem Rand der Druckentlastungsöffnung 18 verbunden sein, beispielsweise über eine mit der Zwischenwand 25 verklebte, verschraubte, verschweißte, verlötete oder sonst wie verbundene Fassung 26, in der der poröse Körper 20 gehalten ist.

Für alle Beispiele und die Ausführungsform gilt, dass der Innenraum 16 des Gehäuses 11 vorzugsweise größer als der Innenraum 17 des Teilgehäuses 12 ist. Nicht dargestellte Komponenten, die potentiell Zündquellen darstellen, können in dem Innenraum 16 angeordnet sein. Der Innenraum 17 ist vorzugsweise frei von Zündquellen.

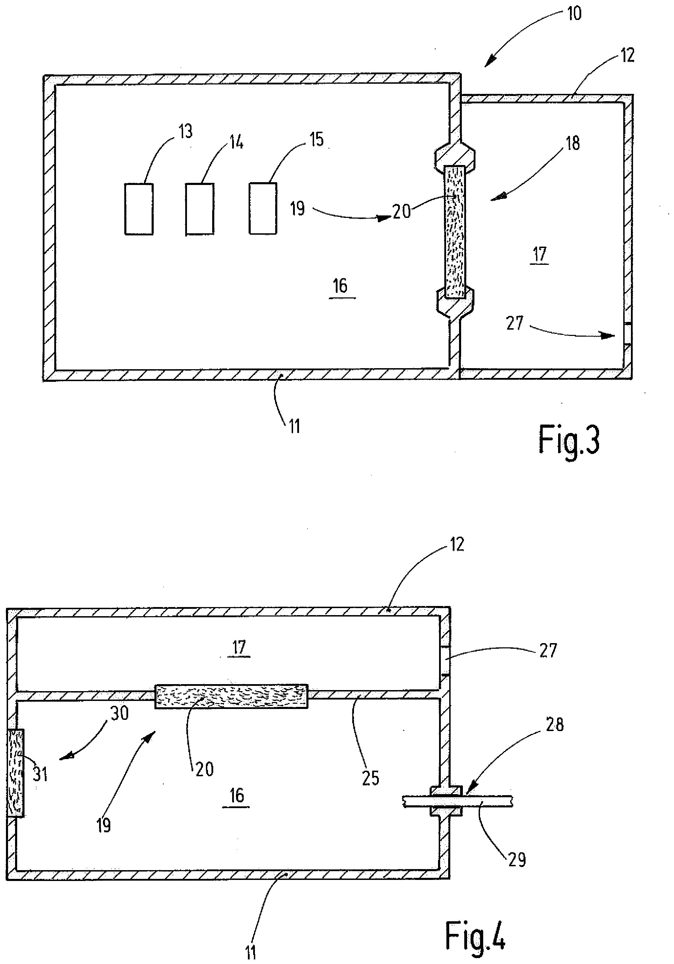

Eine weitere Abwandlung der Gehäuseanordnung 10 ist aus Figur 3 zu entnehmen. Das dort veranschaulichte Beispiel beruht auf der Gehäuseanordnung 10 nach Figur 1 wobei das Teilgehäuse 12 mindestens eine Öffnung 27 aufweist, die den Innenraum 17 mit der freien Umgebung verbindet. Diese Öffnung 27 ist nicht flammendurchschlagsicher ausgebildet. Deswegen sind in dem Innenraum 17 auch keine Zündquellen vorhanden. Jegliche dort angeordneten Komponenten sind so ausgebildet, dass von ihnen keine Explosion ausgehen kann. Es kann sich dabei zum Beispiel um ruhende Kontakte oder andere Mittel handeln. Zündquellen bildende Komponenten 13 bis 15 sind ausschließlich in dem Innenraum 16 angeordnet.

Lediglich beispielhaft ist in diesem Beispiel eine Druckentlastungsvorrichtung 19 vorgesehen, bei der der poröse Körper 20 am Rand der Öffnung 18 mit dem Material des Gehäuses 11 durch Urformen verbunden ist, beispielsweise, indem der poröse Körper 20 beim Gießen des Gehäuses 11 in dessen Gussform eingelegt worden ist und teilweise von dem Gehäusewandmaterial umschlossen wurde. Diese Art der Anordnung des porösen Körpers 20 in oder an der Wand 25 des Gehäuses 11 kann bei jeder der vor- oder nachstehend beschriebenen Beispiele zur Anwendung kommen. Dies sowohl, wenn der Körper 20 die Innenräume 16, 17 miteinander verbindet als auch wenn der poröse Körper 20 den Innenraum 16 mit der Umgebung verbindet.

Ein Beispiel mit doppelter Druckentlastung ist Figur 4 zu entnehmen. Es ist dort eine Gehäusestruktur nach dem Vorbild der Gehäuseanordnung 10 nach Figur 2 dargestellt, wobei der poröse Körper 20 nach jeder der vorbeschriebenen Arten in oder an der Zwischenwand 25 befestigt sein kann. Optional kann der Teilraum 17 über die Öffnung 27 mit der Umgebung verbunden sein.

Zur Veranschaulichung der optionalen Möglichkeit des Vorhandenseins von Durchgängen oder Spalten zwischen dem Innenraum 16 und der Umgebung ist in Figur 4 eine Durchführung 28 für ein mechanisches Element, beispielsweise eine Welle 29 veranschaulicht. Der zwischen der Welle 29 und der entsprechenden Gehäusedurchführung 28 gebildete Spalt ist eng und lang und deswegen flammendurchschlagsicher. Solche oder ähnliche Anordnungen können bei allen vor- oder nachstehend beschriebenen Beispiele vorgesehen sein.

Das Gehäuse 11 kann mit einer weiteren Druckentlastungsanordnung 30 versehen sein, die durch einen porösen Körper 31 gebildet ist. Dieser ist gasdurchlässig und flammendurchschlagsicher. Er kann in Aufbau und Struktur mit dem porösen Körper 20 übereinstimmen, so dass auf dessen Beschreibung entsprechend verweisen wird. Außerdem kann er auf jede der vorgenannten Arten mit der Gehäusewand verbunden sein.

Im Beispiel nach Figur 4 ist der poröse Körper 20 vor Verschmutzung und Witterungseinflüssen geschützt. Der zusätzliche Druckentlastungskörper 30 kann deutlich kleiner ausgebildet sein und an einer geeigneten Gehäusestelle zum Beispiel an der Gehäuseunterseite angebracht sein. Er kann dadurch oder durch weitere Maßnahmen, z.B. eine reißfähige Schutzmembrane gegen Umwelteinflüsse geschützt werden. Solche Membranen können bei Austritt eines Gasstroms zerreißen und den Weg für diesen frei geben. Sie müssen dann aber ersetzt werden. Durch das Druckentlastungsvolumen führen jedoch kleinere Verpuffungen nicht zur Zerstörung einer solchen Schutzmembrane, so dass kein häufiger Membrane-Austausch erforderlich wird.

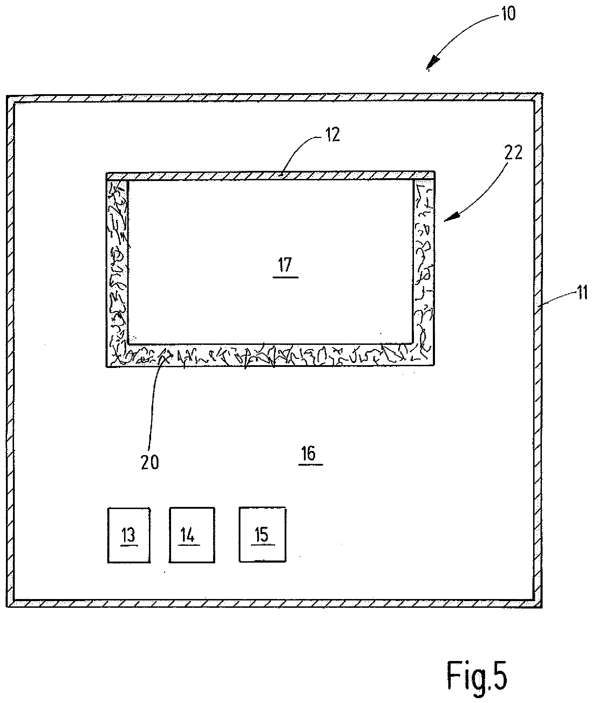

Eine weitere Möglichkeit der Ausbildung eines Druckentlastungsvolumens 22 in dem Gehäuse 11 ist in Figur 5, einer Ausführungsform der vorliegenden Erfindung, veranschaulicht. Bei der dort dargestellten Gehäuseanordnung 10 ist das Teilgehäuse 12 in dem Innenraum 16 angeordnet und somit vollständig von dem Gehäuse 11 umgeben. Die Wandanordnung des Teilgehäuses 12 kann ganz oder teilweise durch den porösen Körper 20 gebildet sein, der entsprechend den Innenraum 17 gegebenenfalls zusammen mit der verbleibenden Gehäusewand des Gehäuses 11 abgrenzt. Der von dem Innenraum 16 abgegrenzte Innenraum 17, der das Druckentlastungsvolumen 22 bildet, ist durch den Druckentlastungskörper 20 wiederum flammendurchschlagsicher abgegrenzt. Wird in dem Innenraum 16 zum Beispiel an einer der Komponenten 13 bis 15 eine Explosion gezündet, baut sich ein Schwall heißer verdichteter Gase auf, die beim Durchdringen des porösen Körpers 20 abkühlen und dadurch an Volumen abnehmen. Das Druckentlastungsvolumen 22 wirkt somit als Schluckvolumen zur wirksamen Herabsetzung von Druckspitzen in den Gehäuse 11.

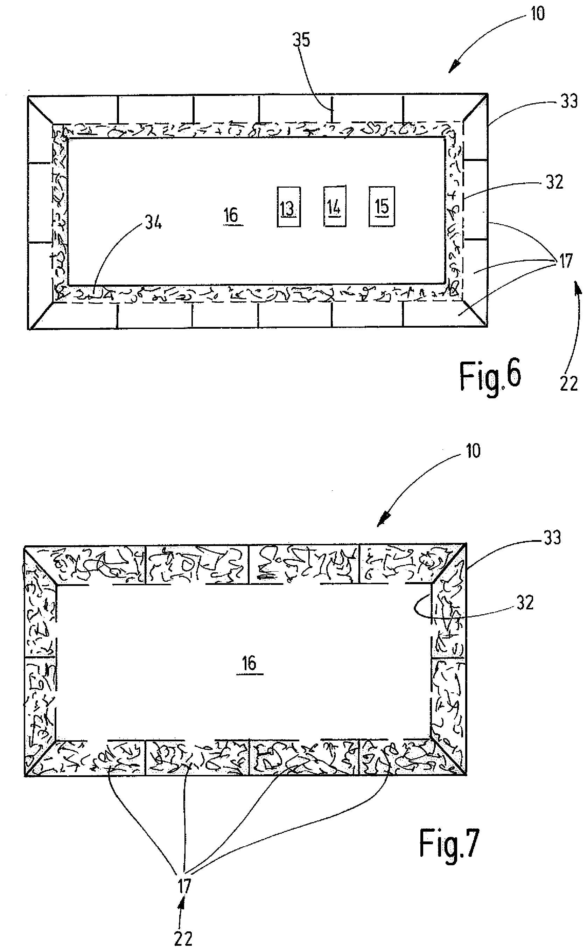

Wie Figur 6 veranschaulicht, als ein nicht zur Erfindung gehörendes Beispiel, ist es auch möglich, die Gehäuseanordnung 10 als doppelwandiges Gehäuse aufzubauen, wobei der von der inneren Gehäusewand 32 umschlossen Innenraum 16 Zündquellen bildende Komponenten 13, 14, 15 aufnehmen kann. Zwischen der inneren Gehäusewand 32 und der äußeren Gehäusewand 33 sind ein oder mehrere Kammern ausgebildet, deren Innenräume 17 gemeinsam das Druckentlastungsvolumen 22 bilden.

Die Innenwand 32 kann mit einer Anzahl von Öffnungen versehen sein, so dass alle zwischen dem Gehäuse 32, 33 vorhandenen Kammern in offener Verbindung zu dem Innenraum 16 stehen. In den Öffnungen können wiederum Druckentlastungskörper angeordnet sein oder, wie es in Figur 6 dargestellt ist, kann eine flammendurchschlagsichere Auskleidung 34 dem Flammendurchschlag in die Kammern 17 verhindern. Dabei ist die flammendurchschlagsichere Auskleidung vorzugsweise durch einen oder mehrere flammendurchschlagsichere poröse Körper, beispielsweise Metallschäume, Metallfilze, Metallgewebe, Metallsinterkörper, Keramiksinterkörper, Keramikfaserkörper und dergleichen gebildet. Durch die Kühlwirkung und Expansionskühlung des die Auskleidung 34 durchdringenden Gases wirkt das Druckentlastungsvolumen 22 als Schluckvolumen zur Vermeidung von Druckspitzen.

Zugleich kann mit dem doppelwandigen Gehäuse ein besonders leichter und stabiler Gehäuseaufbau erreicht werden. Weitere Öffnungen zur Durchleitung von Kabeln oder mechanischen beweglichen Elementen können an der Gehäuseanordnung 10 die Gehäusewände 32, 33 durchbrechend angeordnet sein. Diese Öffnungen sind jedoch ebenfalls flammendurchschlagsicher ausgebildet, wie es bei Ex-d Gehäusen üblich ist.

Ein abgewandeltes Beispiel der Gehäuseanordnung 10 veranschaulicht Figur 7. Es handelt sich dort wiederum um eine zweischaligen Gehäuseaufbau mit einer Innenwand 32 und einer Außenwand 33, zwischen denen einzelne Kammern angeordnet sind, die zusammen den Innenraum 17 und somit das Druckentlastungsvolumen 22 bilden. Die innere Gehäusewand 32 ist mit Öffnungen versehen, so dass vorzugsweise jede der Kammern mit dem Innenraum 16 kommuniziert. Eine oder mehrere der Kammern sind mit einem porösen Material wenigstens teilweise oder auch ganz gefüllt, um eine Abkühlung und somit Volumenverringerung der in den Innenraum 17 laufenden Explosionswelle zu bewirken.

Die erfindungsgemäße Gehäuseanordnung 10 weist einen Innenraum 16 zur Aufnahme von Komponenten 13, 14, 15 auf, die Zündquellen bilden können. Weiter weist die Gehäuseanordnung 10 ein Teilgehäuse 12 auf, das in dem Gehäuse 11 angeordnet ist und dessen Innenraum 17 als Druckentlastungsvolumen 22 dient. Die beiden Innenräume 16, 17 sind über eine Durchgangsöffnung 18 miteinander verbunden, in der eine gasdurchlässige und flammendurchschlagsichere Anordnung 19 vorgesehen ist. Diese kann zum Beispiel durch einen porösen Körper 20 gebildet sein, der gasdurchlässig ausgebildet ist und auf einen durch ihn hindurchtretenden Gasstrom drosselnd und kühlend wirkt.

**Bezugszeichen:**

| | |
|---|---|
| 10 | Gehäuseanordnung |
| 11 | Gehäuse |
| 12 | Teilgehäuse |
| 13 - 15 | Komponenten |
| 16 | Innenraum des Gehäuses 11 |
| 17 | Innenraum des Teilgehäuses 12 |
| 18 | Durchgangsöffnung in der Wand des Gehäuses 11 |
| 19 | flammendurchschlagsichere Anordnung |
| 20 | poröser Körper |
| 21 | Rand des Körpers 20 |
| 22 | Druckentlastungsvolumen |
| 23 | dem Innenraum 16 zugewandte Fläche des Körpers 20 |
| 24 | dem Innenraum 17 zugewandte Fläche des Körpers 20 |
| 25 | Zwischenwand |
| 26 | Fassung |
| 27 | Öffnung |
| 28 | Durchführung |
| 29 | Welle |
| 30 | Druckentlastungsanordnung |
| 31 | poröser Körper |
| 32 | innere Gehäusewand |
| 33 | äußere Gehäusewand |
| 34 | flammendurchschlagsichere Auskleidung |

## Patentansprüche

1. Gehäuseanordnung (10), insbesondere Gehäuse der Schutzart ex-d,
mit einem Gehäuse (11), das einen Innenraum (16) umschließt, der zur Aufnahme von Komponenten geeignet ist, die Zündquellen bilden können,
mit einem in dem Gehäuse (11) angeordneten Entlastungsvolumen (22),
mit einer Durchgangsöffnung (18), die den Innenraum (16) mit dem Druckentlastungsvolumen (22) verbindend angeordnet ist,
mit einer in oder an der Durchgangsöffnung (18) angeordneten, gasdurchlässigen und flammendurchschlagsicheren Anordnung (19),
**dadurch gekennzeichnet, dass** das Druckentlastungsvolumen (22) innerhalb des von dem Gehäuse (11) umschlossenen Innenraums (16) abgegrenzt ist, wobei
das Druckentlastungsvolumen (22) in einem in dem Innenraum (16) angeordneten Teilgehäuse (12) gebildet ist.

2. Gehäuseanordnung nach Anspruch 1, wobei das Teilgehäuse (12) mit dem Gehäuse (11) wenigstens eine Wand gemeinsam hat.

3. Gehäuseanordnung nach einem der vorstehenden Ansprüche, wobei die Durchgangsöffnung (18) wenigstens eine Wandfläche des Teilgehäuses (12) bildet.

4. Gehäuseanordnung nach Anspruch 1, wobei das Teilgehäuse (12) eine Schutzart aufweist, die sich von der Schutzart des Gehäuses (11) unterscheidet.

## Claims

1. Housing arrangement (10), in particular a housing of protection class ex-d,
with a housing (11) enclosing an interior (16) which is suitable for receiving components which may form ignition sources,
with a pressure-relief volume (22) arranged in the housing (11),
with a passage opening (18) which connects the interior (16) to the pressure-relief volume (22),
with a gas-permeable, flame-arresting arrangement (19) arranged in or at the passage opening (18),
**characterised in that** the pressure-relief volume (22) is delimited inside the interior (16) surrounded by the housing (11), wherein
the pressure-relief volume (22) is formed in a part housing (12) arranged in the interior (16).

2. Housing arrangement according to claim 1, wherein the part housing (12) has at least one wall in common with the housing (11).

3. Housing arrangement as claimed in any of the preceding claims, wherein the passage opening (18) forms at least one wall face of the part housing (12).

4. Housing arrangement according to claim 1, wherein the part housing (12) has a protection class which differs from the protection class of the housing (11).

## Revendications

1. Ensemble de boîtier (10), en particulier boîtier avec le mode de protection ex-d,
comprenant un boîtier (11) qui entoure un espace intérieur (16), lequel est adapté pour accueillir des composants pouvant constituer des sources d'inflammation,
comprenant un volume de décharge (22) disposé dans le boîtier 11), comprenant une ouverture de passage (18) qui est disposée de manière à relier l'espace intérieur (16) avec le volume de décharge de pression (22),
comprenant un élément (19) antidéflagrant résistant aux flammes et perméable au gaz, disposé dans l'ouverture de passage (18),
**caractérisé en ce que** le volume de décharge de pression (22) est délimité à l'intérieur de l'espace intérieur (16) entouré par le boîtier (11), le volume de décharge de pression (22) étant formé dans un boîtier élémentaire (12) disposé dans l'espace intérieur (16).

2. Ensemble de boîtier selon la revendication 1, dans lequel le boîtier élémentaire (12) présente au moins une paroi commune avec le boîtier (11).

3. Ensemble de boîtier selon l'une des revendications précédentes, dans lequel l'ouverture de passage (18) forme au moins une surface de paroi du boîtier élémentaire (12).

4. Ensemble de boîtier selon la revendication 1, dans lequel le boîtier élémentaire (12) présente un mode de protection qui est différent du mode de protection du boîtier (11).
